# EUROPÄISCHE PATENTANMELDUNG

(11) **EP 3 716 105 A1**
(43) Veröffentlichungstag der Anmeldung: **30.09.2020**
(21) Anmeldenummer: 19166275.8
(22) Anmeldetag: 29.03.2019
(51) Int. Cl.: G06F 17/50

(54) **SCHALTSCHRANKKONFIGURATIONSSYSTEM**

(71) Anmelder: Rittal GmbH & Co. KG, 35745 Herborn (DE)
(72) Erfinder: MARTIN, Lars, 35516 Münzenberg (DE); WEICHSEL, Thomas, 41812 Erkelenz (DE)
(74) Vertreter: Maiwald Patent- und Rechtsanwaltsgesellschaft mbH

(57) **Zusammenfassung**

Computergestütztes Schaltschrankkonfigurationssystem, eingerichtet zur Konfiguration eines Schaltschranks, der eine modular aufgebaute Schaltschrankausstattung umfasst, die anwendungsspezifisch aus mehreren elektrischen und/oder elektronischen Einbaumodulen und weiteren optionalen Komponenten zusammengesetzt ist, aufweisend eine Recheneinheit mit einer Klassifikationseinrichtung und einer Auswerte- und Simulationseinheit zur Erzeugung eines Bündels von unterschiedlichen Schaltschrankkonzepten mit jeweils unterschiedlichen Layouts, einer darauffolgenden Auswahl eines bestimmten Layouts und einer entsprechenden Steuerung einer Schaltschrankfertigungslinie.

## Beschreibung

### Gebiet der Erfindung

Die vorliegende Erfindung betrifft ein computergestütztes Schaltschrankkonfigurationssystem, eingerichtet zur Konfiguration eines Schaltschranks, der eine modular aufgebaute Schaltschrankausstattung umfasst, die anwendungsspezifisch aus mehreren elektrischen und/oder elektronischen Einbaumodulen und weiteren optionalen Komponenten zusammengesetzt ist. Darüber hinaus betrifft die Erfindung eine Schaltschrankfertigungsanlage, eine Verwendung, ein Verfahren und ein Computerprogrammprodukt.

### Hintergrund

Das Einsatzgebiet der Erfindung erstreckt sich auf den Schaltanlagen- und Steuerungsbau. Schaltschränke werden vornehmlich im Rahmen industrieller Anwendungen genutzt. Ein Schaltschrank beherbergt die elektrischen und elektronischen Komponenten, welche in Form normierter Einbaumodule ausgebildet sind, um eine automatisierte Fertigungsanlage, eine verfahrenstechnische Anlage, eine Werkzeugmaschine oder dergleichen anzusteuern. Bei den im Schaltschrank untergebrachten Einbaumodulen handelt es sich meist um steuerungstechnische Komponenten, die nicht als Feldgeräte direkt an der Maschine angeordnet sind. Als Einbaumodule kommen beispielsweise speicherprogrammierbare Steuerungen, universelle Recheneinheiten, Frequenzumrichter für Drehzahlsteuerungen, Kommunikationsmodule für Busanbindungen zu unterschiedlichen Bussystemen, digitale Eingangs-/Ausgangs-Module oder auch analoge Eingangsmodule zum Einsatz. Daneben enthält ein Schaltschrank üblicherweise auch elektrische Klemmleisten zum Anschluss der elektrischen Verkabelung am Einsatzort, womit die Verbindung zur Stromversorgung und den anzusteuernden Maschinen und Anlagen hergestellt wird. Die Fertigung eines Schaltschranks mit der anwendungsspezifischen Schaltschrankausstattung erfolgt nach Maßgabe eines zuvor im Konzeptionsstadium erarbeiteten dreidimensionalen Layouts, welches auch die Stücklisteninformationen der zu verbauenden Komponenten umfasst.

Aus der WO 2008/071309 A1 geht eine Schaltschrankanordnung mit mehreren einzelnen Schaltschränken hervor, die mittels Wandabschnitten in mehrere als Funktionsräume dienende Teilräume unterteilt sind, worin beispielsweise Niederspannungsanlagen, Einschübe, Kühlaggregate und andere Komponenten platzierbar sind. Dabei kann ein Teilraum beispielsweise eine elektrische Verteilschienenanordnung und hierauf aufgesetzte Geräteadapter zur Montage zugeordneter elektrischer oder elektronischer Einbaumodule aufnehmen.

Die EP 0 943 165 B1 offenbart verschiedene Ausstattungskonzepte von Schaltschränken. Bei einem ersten Ausführungsbeispiel umfasst ein baugruppenorientierter Schaltschrank ein Schaltschrankgehäuse, in dem mehrere elektrische und elektronische Bauteile und Geräte angeordnet sind. Im oberen Bereich des Schaltschrankgehäuses befinden sich mehrere Ein/Ausgabemodule, im mittleren Bereich sind mehrere Sicherungselemente und eine größere Anzahl von Leistungsschaltern platziert und im unteren Bereich sind Klemmeinrichtungen zur Befestigung von Kabelsträngen, die zu einzelnen Maschinen führen, untergebracht. Zur Verbindung der einzelnen Bauteile und Geräte untereinander sind in dem Schaltschrank mehrere Klemmen zur Zugangsverdrahtung, mehrere Klemmen zur Zwischenrangierung und mehrere Klemmen zur Abgangsrangierung angeordnet.

### Zusammenfassung

Es ist eine Aufgabe der Erfindung, ein Schaltschrankkonfigurationssystem zur Konfiguration eines Schaltschranks anzugeben, bei dem das Layout in für den Nutzer effizienter Weise mit guter Balance von möglichen Optimierungsaspekten gestaltet werden kann.

Die Aufgabe wird gemäß den Merkmalen der unabhängigen Patentansprüche gelöst. Weiterbildungen der Erfindung ergeben sich aus den Unteransprüchen und der folgenden Beschreibung.

Ein erster Aspekt betrifft ein computergestütztes Schaltschrankkonfigurationssystem, eingerichtet zur Konfiguration eines Schaltschranks, der eine modular aufgebaute Schaltschrankausstattung aufweist, die anwendungsspezifisch aus mehreren elektrischen und/oder elektronischen Einbaumodulen und weiteren optionalen Komponenten zusammengesetzt ist. Das computergestützte Schaltschrankkonfigurationssystem weist eine Recheneinheit auf, die eine Klassifikationseinrichtung und eine Auswerte- und Simulationseinheit umfasst. Darüber hinaus ist eine Datenbank vorgesehen, bei der es sich auch um einen Cloud-Speicher handeln kann. Die Klassifikationseinrichtung ist eingerichtet, unter Berücksichtigung eines Rahmenbedingungsdatensatzes eine oder mehrere Schaltschrankkonfigurationen für eine zu regelnde Anlage zu identifizieren, indem sie geeignete Konfigurationen aus einem in der Datenbank gespeicherten historischen Vorratsdatensatz auswählt. Diese gespeicherten Konfigurationen umfassen insbesondere Konfigurationen von Schaltschränken, die bereits produziert wurden, also erfolgreich im Einsatz sind. Die Auswerte- und Simulationseinheit ist eingerichtet, die unter Berücksichtigung des Rahmenbedingungsdatensatzes identifizierten Schaltschrankkonfigurationen innerhalb eines durch unterschiedliche Parameter aufgespannten Parameterraumes anzupassen, so dass ein Bündel von unterschiedlichen Schaltschrankkonzepten mit jeweils unterschiedlichen (dreidimensionalen) Layouts erzeugt wird.

Die Auswerte- und Simulationseinheit kann eingerichtet sein, für jedes Schaltschrankkonzept des Bündels Abweichungen von den im Rahmenbedingungsdatensatz definierten Rahmenbedingungen und gegebenenfalls den sich daraus ergebenden Zielsetzungen zu berechnen und grafisch auszugeben.

Der Rahmenbedingungsdatensatz kann insbesondere eine gewünschte Spezifikation des Schaltschranks umfassen. Die Zielsetzungen können insbesondere eine Herstellungszeit und/oder die Herstellungskosten des Schaltschranks umfassen.

Das Schaltschrankkonfigurationssystem kann darüber hinaus eingerichtet sein, den Rahmenbedingungsdatensatz mittels eines ersten elektronischen Auswahlformulars durch Interaktion mit einem Benutzer zu erstellen.

Gemäß einer Ausführungsform ist darüber hinaus eine Mustererkennungseinheit vorgesehen, welche die Klassifikationseinrichtung verwendet, um die eine oder mehreren Schaltschrankkonfigurationen mittels Mustererkennung zu identifizieren.

Die Mustererkennungseinheit kann hierfür zur Mustererkennung eine Fuzzy-Logik, künstliche Intelligenz oder neuronale Netze einsetzen.

Gemäß einer weiteren Ausführungsform ist die Auswerte- und Simulationseinheit eingerichtet, die Parameter des Parameterraumes mittels eines zweiten elektronischen Auswahlformulars zu erstellen. Auch dieses kann durch Interaktion mit einem Benutzer erzeugt oder komplettiert werden.

Gemäß einer weiteren Ausführungsform umfassen die Parameter, welche den Parameterraum aufspannen, Fertigungstiefe, Platzbedarf und/oder Kosten des Schaltschranks.

Gemäß einer weiteren Ausführungsform ist eine Entscheidungseinrichtung vorgesehen, eingerichtet zur Auswahl eines Schaltschrankkonzepts aus dem Bündel aus unterschiedlichen Schaltschrankkonzepten. Diese Entscheidungseinrichtung kann eingerichtet sein, Benutzereingaben entgegenzunehmen. Sie kann auch komplett automatisiert eingerichtet sein, so dass das computergestützte Schaltschrankkonfigurationssystem die Auswahl selbstständig vornimmt. Diese Auswahl kann eine weiter unten beschriebene Gütefunktion berücksichtigen.

Gemäß einer weiteren Ausführungsform ist das System eingerichtet zum Hinterlegen der Schaltschrankkonfiguration des ausgewählten Schaltschrankkonzeptes in der Datenbank, so dass das System bei einer zukünftigen Schaltschrankkonfiguration darauf zurückgreifen kann.

Eine solche Konzeptionierung und Konstruktion von Schaltschrankausstattungen wird softwarebasiert, beispielsweise durch EPLAN Pro Panel® in Form einer CADunterstützten Konstruktion erstellt. Die geplante Konstruktion umfasst insbesondere den dreidimensionalen Montageaufbau in Form eines Layouts, eine virtuelle Verdrahtung der elektrischen und elektronischen Einbaumodule und gegebenenfalls anderer Komponenten sowie eine auf die Schaltschrankausstattung abgestimmte Konfiguration von Kupferschienen und dergleichen für flexible Stromverteilersysteme. Die elektrischen oder elektronischen Einbaumodule können beispielsweise über Hutschienen im Schaltschrankgehäuse befestigt werden. Zur Komplettierung des Schaltschranks können auch optionale Komponenten, wie Ventilatoren, Lüfter, Filter, Wärmetauscher, Klimatisierungseinheiten, Innenbeleuchtungssysteme, Kabeleinführungen und dergleichen konzipiert werden.

Die durchgeführte softwareunterstützte Konstruktion zur Erstellung des dreidimensionalen Layouts zeichnet sich durch eine Klassifikationseinrichtung und eine Auswerte- und Simulationseinheit aus, die im Zugriff auf eine hieran angeschlossene Einbaumodul-Bibliothek (Datenbank) das Layouten der Schaltschrankausstattung unter Beachtung der baulichen Randbedingungen, beispielsweise Abstandsmaße, Zugänglichkeit oder elektrische Energieverbrauchsvorgabe unterstützt.

In dem Schaltschrankgehäuse können auf einer gemeinsamen Tragschiene verschiedene Einbaumodule befestigt sein. Der Schaltschrank ist funktionsblockorientiert aufgebaut, das heißt, dass nur diejenigen Einbaumodule enthalten sind, die für die Funktion einer Maschine notwendig sind. Darüber hinaus beinhaltet das Schaltschrankgehäuse auch mehrere Busklemmen zum Anschluss des Schaltschranks an ein Bussystem, eine Signalüberwachungseinheit, mehrere Ein/Ausgabemodule, ein Netzteil sowie Lastrelais. Im Boden des Schaltschrankgehäuses befinden sich Kabeldurchführungen, durch welche die Anschlussleitungen für Maschinen sowie Leitungen für zusätzliche Sensoren und/oder Aktoren in das Innere des Schaltschranks geführt werden können. Dieser Schaltschrank des zweiten Ausführungsbeispiels ist so ausgeführt, dass dieser mindestens der Schutzklasse IP65 entspricht.

Das Layout von Schaltschränken muss im Regelfall aus der Anwendung heraus definierte Rahmenbedingungen erfüllen und kann darüber hinaus nach zusätzlichen Aspekten optimiert werden, beispielsweise hinsichtlich der thermischen Belastbarkeit, der elektromagnetischen Verträglichkeit, der Packungsdichte an Einbaumodulen und sonstigen Komponenten, des elektrischen Energieverbrauchs und dergleichen. Allerdings stehen diese Optimierungsaspekte zumeist in einem konkurrierenden Verhältnis zueinander, so dass die Optimierung in Richtung eines Aspekts zu Lasten eines anderen Aspekts geht. Beispielsweise führt die Erhöhung der Packungsdichte meist zu einer höheren thermischen Belastung des Schaltschranks.

Ausführungsformen schließen die technische Lehre ein, dass die Konfiguration eines Schaltschranks zunächst von der Erstellung oder Bereitstellung einer funktionalen Planung der Schaltschrankausstattung in Form eines elektrischen Schaltplans SP ausgeht. Anschließend erfolgt eine Umwandlung des elektrischen Schaltplans SP der Schaltschrankausstattung in ein dreidimensionales Layout L1 zur Anordnung von zumindest mehreren elektrischen und/oder elektronischen Einbaumodulen in mindestens einem Schaltschrankgehäuse, wobei das dreidimensionale Layout L1 der Schaltschrankausstattung durch eine softwaretechnische Layout-Assistenzeinheit LA - beispielsweise das Produkt EPLAN Pro Panel® der Anmelderin - in Zugriff auf eine hieran angeschlossene Einbaumodul-Bibliothek erstellt wird.

Es kann vorgesehen sein, dass anschließend eine Modifikation des so erstellten dreidimensionalen Layouts L1 durch einen in der Layout-Assistenzeinheit LA implementierten Abwandlungsalgorithmus Mod zur Erzeugung mindestens eines alternativen dreidimensionalen Layouts L2 erfolgt. Dabei ermittelt der Abwandlungsalgorithmus Mod zur Abwandlung des dreidimensionalen Layouts L1 in das alternative Layout L2 Werte einer Gütefunktion und optimiert die Abwandlung dergestalt, dass die Gütefunktion ein Extremum annimmt. Anschließend kann eine Übergabe des Schaltschranks gemäß dem alternativen dreidimensionalen Layout L2 an die Montagewerkstatt erfolgen.

Der Abwandlungsalgorithmus macht sich die mathematische Gütefunktion zunutze. In der Gütefunktion ist das Ziel verkörpert, welches mit der Abwandlung erreicht werden soll, beispielsweise eine Erhöhung des Raumnutzungsgrades, also der Packungsdichte. Falls mehrere Ziele gleichzeitig erreicht werden sollen, so bietet dieses mathematische Modell die Voraussetzung dafür, dass im Falle von Zielkonflikten Kompromisse im Sinne eines kleinsten gemeinsamen Nenners auffindbar sind. Neben der Gütefunktion können auch harte Randbedingungen vorgegeben werden, wie eine Maximaltemperatur oder ein maximaler Energieverbrauch. Pro Layout-Variante kann eine Auswertung in mehreren Durchläufen stattfinden, welche mit der Gütefunktion getestet werden. Zur Suche der jeweils nächsten Variante kann ein beliebiges Optimierungsverfahren genutzt werden, das aus der Vorgeschichte der bisherigen Varianten eine neue Variante mit voraussichtlich verbessertem Wert der Gütefunktion ableitet.

Mit anderen Worten wird durch den Planer zunächst ein dreidimensionales Layout L1 in Umsetzung des elektrischen Schaltplans SP unter Nutzung der softwaretechnischen Layout-Assistenz erstellt. Anschließend kann vorgegeben werden, dass das dreidimensionale Layout, was auf beispielsweise zwei Schaltschränke verteilt angeordnet ist, gemäß dem originären Layout L1, auf eine geringere Montagefläche eines einziges Schaltschranks passen soll. Nach Maßgabe dieser Vorgabe erstellt der Abwandlungsalgorithmus Mod einen entsprechend angepassten Vorschlag für ein modifiziertes Layout L2, eventuell unter Missachtung von normalerweise geltenden Abstandsmaßen oder dergleichen. Da in diesem Fall jedoch ein höherer Raumnutzungsgrad Priorität vor vorgegebenen Abstandsmaßen hat, wird dem modifizierten Layout L2 Vorzug gegeben. Eventuell hieraus resultierende höhere Wärmeentwicklungen können dann beispielsweise durch Verbau einer Kühlungseinrichtung mit höherer Kühlleistung kompensiert werden.

Falls eine Vorzertifizierung des alternativen dreidimensionalen Layouts L2 ergibt, dass diese Ausführungsform zulässig ist, so kann vorgesehen sein, dass dieses alternative dreidimensionale Layout L2 in der mit der Layout-Assistenzeinheit LA verbundenen Anwendungs-Datenbank A hinterlegt wird, um dieses bei zukünftigen Umwandlungen gleicher oder ähnlicher elektrischer Schaltpläne SP' als originär zulässiges Layout zu berücksichtigen. Durch diese Maßnahme erfolgt eine Anreicherung der Anwendungs-Datenbank A, welche insoweit nicht allein auf Ausführungsformen beschränkt wird, bei denen vorgegebene bauliche Randbedingungen und dergleichen starr beachtet werden. Durch diese Flexibilität ist ein stärker anwendungsorientiertes Layouten von Schaltschrankausstattungen möglich. Somit schafft die erfindungsgemäße Lösung eine Vorgehensweise, welches bei der Erstellung eines Layouts für einen Schaltschrank einzelne Optimierungsmöglichkeiten einschließlich ihrer Wechselwirkung zueinander berücksichtigt.

Systemtechnisch lässt sich diese Lösung durch eine zusätzliche Implementierung oder Zuordnung des Abwandlungsalgorithmus Mod in die Layout-Assistenzeinheit LA, welche ein Computer mit hierauf installierter Software EPLAN Pro Panel® sein kann, umsetzen.

Beispielsweise weist der Abwandlungsalgorithmus Mod eine parametrierbare Gütefunktion auf, die mindestens einen änderbaren Layout-Optimierungsparameter P1 bis Pn enthält. Dieser Layout-Optimierungsparameter stellt dem Planer - beispielsweise mittels eines auf einer grafischen Benutzeroberfläche nachgebildeten Drehreglers - für verschiedene Optimierungsrichtungen eine Eingabemöglichkeit bereit, um gewünschte Gewichtungen für eine Layout-Änderung zu wählen. Das System ermittelt anhand des Abwandlungsalgorithmus Mod ein aufeinander abgestimmtes, sinnvolles Verhältnis von verschiedenen vorgegebenen Layout-Optimierungsparametern und schlägt ein zugehöriges alternatives Layout L2 vor. Im einfachsten Fall ist es jedoch auch denkbar, dass nur ein einziger Layout-Optimierungsparameter vorgebbar ist. Verschiedene Layout-Optimierungsparameter P1 bis Pn sind denkbar, wovon nachfolgend eine nicht einschränkende Auswahl angegeben wird:
Ein erster Layout-Optimierungsparameter P1 beschreibt den Raumnutzungsgrad des zur Verfügung stehenden Schaltschrankvolumens im Verhältnis zu geometrischen Abmessungen der hierin zu verbauenden elektrischen und/oder elektronischen Einbaumodule.

Ein zweiter Layout-Optimierungsparameter P2 beschreibt einen thermischen Belastungsgrad unter Berücksichtigung der von den Einbaumodulen erzeugten Abwärme, der Umgebungswärme des Schaltschranks und gegebenenfalls der Wärmeabfuhrleistung einer optionalen Lüfter-/Klimaeinheit.

Ein dritter Layout-Optimierungsparameter P3 beschreibt den elektrischen Energieverbrauchsgrad unter Berücksichtigung zumindest der elektrischen Leistungsaufnahme aller Einbaumodule. Zwar hängt die elektrische Gesamtleistung von der elektrotechnischen Auslegung der Schaltschrankausstattung ab, jedoch könnten alternative Einbaumodule in Frage kommen, die sich bei derselben Funktion in der Leistungsaufnahme unterscheiden. Daher kann auch dahingehend optimiert werden.

Ein vierter Layout-Optimierungsparameter P4 beschreibt einen EMV-Grad (EMV = elektromagnetische Verträglichkeit), welcher die elektromagnetische Emission der Einbaumodule berücksichtigt.

Ein fünfter Layout-Optimierungsparameter P5 beschreibt den Verdrahtungslängen-Grad, um Vorgaben hinsichtlich minimaler oder maximaler Kabellängen bei der Anordnung von Einbaumodulen im Schaltschrankgehäuse zu berücksichtigen.

Da einige dieser hier nur exemplarisch angegebenen Layout-Optimierungsparameter P1 bis P5 in Konkurrenz zueinander stehen, also die Optimierung hinsichtlich eines Parameters zu Lasten eines anderen Parameters gehen kann, ermöglicht die mathematische Methodik der parametrierbaren Gütefunktion eine bestmögliche Balance zwischen verschiedenen Optimierungsparametern, um einen diesbezüglichen Kompromiss aufzufinden. Dabei kann im Sinne einer Priorisierung einem Parameter eine höhere Priorität als einem anderen Parameter beigemessen werden. Mithilfe des erfindungsgemäßen Abwandlungsalgorithmus Mod ist es also möglich, die Schaltschrankausstattung bezüglich unterschiedlicher Kriterien hinsichtlich Raumnutzung, thermischer Belastung, elektrischer Energieverbrauch, EMV, Materialaufwand für Verdrahtung und dergleichen zu optimieren.

Ein weiterer Aspekt betrifft eine Schaltschrankfertigungsanlage, eingerichtet zur Fertigung eines Schaltschranks, aufweisend ein computergestütztes Schaltschrankkonfigurationssystem, so wie oben und weiter unten beschrieben, sowie eine zumindest teilautomatisierte, oder vollautomatisierte, Fertigungslinie, eingerichtet zur zumindest teilautomatisierten, oder vollautomatisierten, Montage des Schaltschranks gemäß einem vom Schaltschrankkonfigurationssystem erzeugten Schaltschrankkonzept.

Ein weiterer Aspekt betrifft die Verwendung eines oben und im Folgenden beschriebenen computergestützten Schaltschrankkonfigurationssystems zur vollautomatisierten Fertigung eines Schaltschranks.

Ein weiterer Aspekt betrifft ein Verfahren zur Konfiguration eines Schaltschranks, der eine modular aufgebaute Schaltschrankausstattung umfasst, die anwendungsspezifisch aus mehreren elektrischen und/oder elektronischen Einbaumodulen und weiteren optionalen Komponenten zusammengesetzt ist. Bei dem Verfahren werden unter Berücksichtigung eines Rahmenbedingungsdatensatzes eine oder mehrere Schaltschrankkonfigurationen für eine zu regelnde Anlage identifiziert, indem geeignete Konfigurationen aus einem in einer Datenbank gespeicherten historischen Vorratsdatensatz ausgewählt werden. Daraufhin erfolgt eine Anpassung der unter Berücksichtigung des Rahmenbedingungsdatensatzes identifizierten Schaltschrankkonfigurationen innerhalb eines durch unterschiedliche Parameter aufgespannten Parameterraumes, so dass ein Bündeln von unterschiedlichen Schaltschrankkonzepten mit jeweils unterschiedlichen Layouts erzeugt wird. Daraufhin erfolgt die Auswahl eines der Schaltschrankkonzepte mit einem bestimmten Layout aus dem Bündel von unterschiedlichen Schaltschrankkonzepten, woraufhin der Schaltschrank gemäß dieses ausgewählten Schaltschrankkonzepts gefertigt wird.

Ein letzter Aspekt betrifft ein Computerprogrammprodukt mit Programmcodemitteln zur Durchführung des Verfahrens, wenn das Computerprogrammprodukt auf einer Recheneinheit einer Schaltschrankfertigungsanlage abläuft oder auf einem computerlesbaren Datenträger oder in einem Cloud-Speicher abgespeichert ist.

Weitere Ausführungsformen werden nachstehend anhand der Figuren näher dargestellt. Es zeigt:
Fig. 1 eine schematische Darstellung eines computergestützten Schaltschrankkonfigurationssystems zur Konfiguration eines Schaltschranks;
Fig. 2 eine schematische Darstellung einer Schaltschrankfertigungsanlage;
Fig. 3 eine Ablaufdarstellung des von dem System durchgeführten Verfahrens zur optimierbaren Konfiguration eines Schaltschranks;
Fig. 4 eine detailliertere schematische Darstellung eines computergestützten Schaltschrankkonfigurationssystems zur Konfiguration eines Schaltschranks.

### Detaillierte Beschreibung von Ausführungsformen

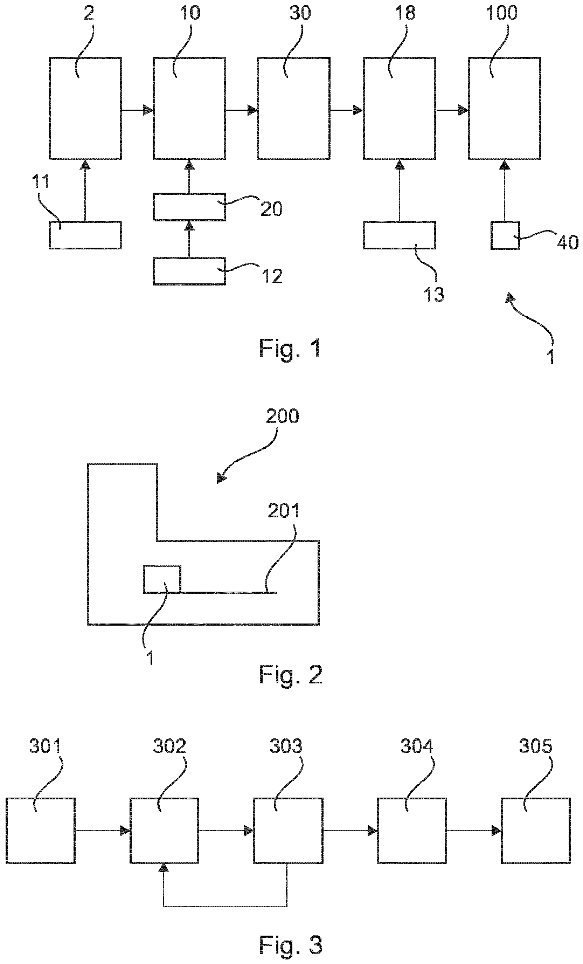

Fig. 1 zeigt eine schematische Darstellung eines computergestützten Schaltschrankkonfigurationssystems 1 zur Konfiguration eines Schaltschranks. Das Schaltschrankkonfigurationssystem 1, im Folgenden auch als "Konfigurationstool" bezeichnet, umfasst als wesentliche Bestandteile eine Klassifikationseinrichtung 10 und eine Auswerteinheit / Simulationseinheit 18.

Mittels des Schaltschrankkonfigurationssystems 1 wird aus Rahmenbedingungen 2, welche eine gewünschte Spezifikation des Schaltschrankes also beispielsweise eine gewünschte Funktionalität oder eine Regelungsaufgabe umfassen, sowie den daraus resultierenden Zielsetzungen welche die betriebswirtschaftlichen Parameter des Projektes, also beispielsweise die Kosten oder die Durchlaufzeiten, beschreiben, ein Schaltschrankkonzept 100 für eine zu regelnde Anlage erstellt. Dabei wird das Schaltschrankkonzept 100 einer konkret ausführbare Konfiguration mit den daraus resultierenden Zielsetzungen beschrieben, so dass keine Notwendigkeit mehr besteht, die vom Schaltschrankkonfigurationssystems ausgegeben Informationen weiter detaillieren oder interpretieren zu müssen, z.B. die Auswahl von Komponenten verschiedener Hersteller.

Der Rahmenbedingungsdatensatz 2 wird beispielsweise mittels eines ersten elektronischen Auswahlformulars konfiguriert, wobei die die zur Beschreibung der Rahmenbedingungen notwendigen Informationen z.B. über die zu regelnde Anlage (Energieverbrauch, Einsatzort, etc.), über die Umfeldbedingungen (Temperatur, etc.), über die geometrischen Parameter (Größe/Anordnung des Klimagerätes, etc.), Komponentenpräferenzen (Hersteller/Ausführung) in einer Datenbankpartition 11 hinterlegt sind.

Der Rahmenbedingungsdatensatz 2, welche in der Regel eine Anzahl an Einzeldaten umfasst, wird an eine Klassifikationseinrichtung 10 übergeben. Die Klassifikationseinrichtung 10 ermittelt aus den Rahmenbedingungen mittels einer mit Mustererkennungseinheit 20 mindestens eine Schaltschrankkonfiguration 30 mit den im Rahmenbedingungsdatensatz 2 verankerten Rahmenbedingungen, indem sie geeignete Konzepte / Konfigurationen aus einem gespeicherten, historischen Vorrat auswählt. Diese Konzepte sind in einer Datenbank(partition) 12 hinterlegt.

Die Mustererkennungseinheit 20 bedient sich der Technologien und Methoden der Mustererkennung und/oder Fuzzy-Logic und/oder neuronaler Netzwerke.

Die so identifizierten Schaltschrankkonfiguration 30 wird mittels der Auswerteinheit / Simulationseinheit 18 innerhalb eines durch unterschiedliche Parameter aufgespannten Parameterraumes angepasst. Diese unterschiedlichen Parametersätze sind in einer Datenbank(partition) 13 hinterlegt. Beispielsweise enthält der Parameterraum Parametersätze zu den unterschiedlichen Fertigungsvarianten, insbesondere Informationen zur Automatisierungstiefe der Fertigungsvarianten und die daraus resultierenden Auswirkungen auf die Rahmenbedingungen, wie z.B. Platzbedarf und die Auswirkungen auf die Zielsetzungen, sowie übergeordnete veränderbare Zielsetzungen wie z.B. das maximale Kostenbudget. Die einzelnen Parameter der Parametersätze werden beispielsweise mittels eines zweiten elektronischen Auswahlformulars ausgewählt. Die Auswerteinheit / Simulationseinheit 18 simuliert, z.B. durch numerische Simulation, ausgehend von mindestens einer Schaltschrankkonfiguration 30 die durch die Rahmenbedingungen 2 und den durch die ausgewählten Parametersätze definierten Parameterraum ein Bündel von Schaltschrankkonzepten 100.

Die Auswerteinheit / Simulationseinheit 18 kann eingerichtet sein, für jedes Schaltschrankkonzept des Bündels die Abweichungen von den geforderten Rahmenbedingungen des Rahmenbedingungsdatensatzes 2 und den Zielsetzungen zu berechnen und graphisch auszugeben. Die Auswahl der zu fertigenden Schaltschrankkonfiguration erfolgt mittels der Entscheidungseinrichtung 40.

Bei der Konstruktion und Produktion von Schaltschränken handelt sich es um einen äußerst komplexen Sachverhalt, welcher sich in unterschiedlichen Dimensionen aufspalten lässt.

### Dimension der Wertschöpfungskette:

Die Konstruktion/Produktion von Schaltschränken lässt sich in mehrere Wertschöpfungsstufen unterteilen (Engineering, Arbeitsvorbereitung, Auftragsplanung und Umsetzung), wobei jede dieser Wertschöpfungsstufen über eine Vielzahl von Freiheitsgraden verfügen und in der Regel von mehreren Teilnehmern des Ecosystem erbracht werden.

### Dimension der Losgröße:

Jeder Schaltschrank kann als Einzelstück angesehen werden da, für jeden Satz von Rahmenbedingungen und Zielsetzungen eine Vielzahl von Planungsoptionen im Engineering möglich sind, diese können sich z.B. in Form der Elektrokonstruktion oder der Komponentenauswahl unterscheiden.

Ist der Schaltschrank konfiguriert, lässt er sich auf unterschiedliche Arten, z.B. verschiedene Automatisierungstiefen fertigen, wobei die Fertigungsvariante direkte Auswirkungen auf die Engineeringphase hat, z.B. automatische Bestückung limitiert die Packungsdichte.

### Dimension der Rahmenbedingungen:

Unter Rahmenbedingungen werden Vorgaben, z.B. geometrischer Natur, bevorzugte Komponenten unterschiedlicher Hersteller oder der Funktionsumfang, des Auftraggebers verstanden. Diese Rahmenbedingungen können dazu führen, dass z.B. bestimmte Fertigungsvarianten nicht durchführbar sind.

### Dimension der Zielsetzungen:

Zielsetzungen können als betriebswirtschaftliche Parameter (Präferenzen) verstanden werden, diese beschreiben die dominanten Aspekte, welche über allen Wertschöpfungsstufen die einzelnen Entscheidungen beeinflussen.

### Dimension der Fertigungsvarianten:

Verschieden Fertigungspartner verfügen über eine unterschiedliche Fertigungsinfrastruktur, welche sich im Wesentlichen durch verschiedene Automatisierungstiefen differenzieren (siehe Losgröße Fertigungsvarianten).

Durch das Schaltschrankkonfigurationssystem, welches wertschöpfungsstufenübergreifend Informationen bereitstellt und ggf. einen Zugriff auf vergangene Projekte zulässt, kann der Planungsaufwand maßgeblich reduziert und Optimierungsansätze aufgezeigt werden.

Die hier adressierten Kundennutzen sind zum Großteil vom Inhalt der zu bestimmenden Optimierungsansätzen abhängig. Allgemein werden folgende Kundennutzen bedient:
1) Ease of Use: Das System schlägt situationsabhängig für jede Wertschöpfungsstufe unterschiedliche Schaltschrankkonfigurationen vor und zeigt dazu die jeweiligen Konsequenzen für die nachgelagerten Schritte an, z.B. Durchführbarkeit der automatischen Verdrahtung.
2) Planungssicherheit: Durch eine Verknüpfung von betriebswirtschaftlichen Parametern, z.B. Kosten oder Ressourcen lässt sich z.B. die Rentabilität das Gesamtprojekts simulieren.
3) Flexibilität: Basieren auf den Ergebnissen des Engineerings lässt sich in jeder Wertschöpfungsstufe die Art und Weise der Umsetzung einzeln simulieren.

Es wird ein Schaltschrankkonfigurationssystem bereitgestellt, welches es ermöglicht in Abhängigkeit von mehreren Parametern eine ideale Konfiguration eines Schaltschrankes vorzuschlagen, wobei das System:
über eine Datenbank mit verschieden Partitionen verfügt,
wobei in einer Partition die Rahmenbedingungen (Kundenvorgaben),
in einer Partition die Zielsetzungen (Präferenzen),
in einer Partition die Fertigungsvarianten (Präferenzen)
in einer Partition bereits umgesetzte Konfigurationen hinterlegt sind;
über Verknüpfungsvorschriften verfügt, welche die Rahmenbedingungen in einer geeigneten Form mit den Zielsetzungen verknüpften;
über Verknüpfungsvorschriften verfügt, die Konfiguration mit verschiedenen Fertigungsvarianten verknüpfen;
über eine Mustererkennungseinheit verfügt, welche zu vorgegebenen Rahmenbedingungen und Zielsetzungen in einem vorgebbaren Abweichungsintervall ähnliche bekannte Konfigurationen erkennt und Konfigurationsvorschläge ausgibt;
über eine Simulationseinheit verfügt, welche für verschiedenen Konfigurationen mögliche (virtuelle) Fertigungsvarianten, Elektrokonstruktionen simuliert;
über eine Auswerteeinheit verfügt, welche die Ergebnisse der jeweiligen Simulationen in Abhängigkeit zu den verschiedenen Zielsetzungen bewertet und das Ergebnis darstellt und in den jeweiligen Wertschöpfungsstufen anpassbar ist, z.B. Anpassung der vorgeschlagenen Fertigungsvariante auf die reale Fertigungsinfrastruktur.

Fig. 2 zeigt eine Schaltschrankfertigungsanlage 200, die ein oben beschriebenes Schaltschrankkonfigurationssystem 1 aufweist, welches mit der voll- oder teilautomatisierten Fertigungslinie 201 verbunden ist und somit die Roboter der Fertigungslinie steuert.

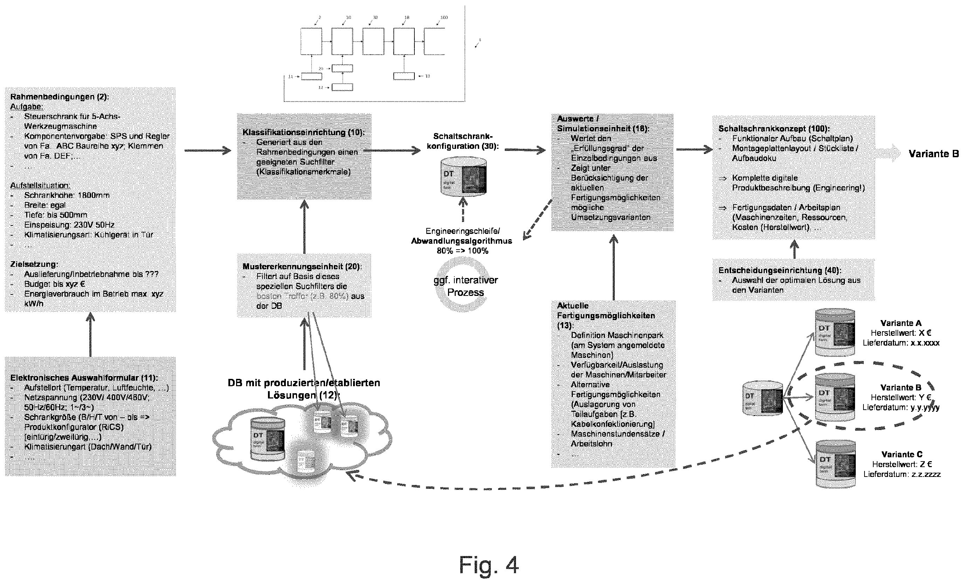

Fig. 3 zeigt ein Flussdiagramm eines Verfahrens zur Konfiguration eines Schaltschranks, bei dem in Schritt 301, wie weiter oben beschrieben, eine oder mehrere Schaltschrankkonfigurationen identifiziert werden, in Schritt 302, wie oben beschrieben, ein Bündel von unterschiedlichen Schaltschrankkonzepten erzeugt wird, in Schritt 303 eine Auswahl eines Schaltschrankkonzeptes mit einem Layout für einen zu fertigenden Schaltschrank aus dem Bündel unterschiedlicher Schaltschrankkonzepte ausgewählt wird. Bestimmt das System, dass das ausgewählte Schaltschrankkonzept den vorgegebenen Anforderungen nicht entspricht, kann es an die Auswerte- und Simulationseinheit zurückgegeben werden, welche daraus dann unter Berücksichtigung gegebenenfalls geänderter Parameter ein neues Bündel an Schaltschrankkonzepten erzeugt. Diese Regelschleife kann mehrfach durchlaufen werden, bis das Schaltschrankkonzept optimiert ist. In Schritt 304 wird der Schaltschrank dann entsprechend dem ausgewählten endgültigen Schaltschrankkonzept gefertigt wird. In Schritt 305 wird das ausgewählte Schaltschrankkonzept (siehe auch gestrichelter, unterer Pfeil in Fig. 4) in der Datenbank 12 zur späteren Verwendung durch die Klassifikationseinrichtung gespeichert. Insbesondere kann das System somit als selbstlernendes System aufgebaut sein, das sein "Wissen" stetig steigert. Die in der Datenbank 12 gespeicherten Schaltplankonfigurationen können insbesondere zur Erstellung von Schaltschrankkonzepten für zukünftige Kunden verwendet werden, welche sich beispielsweise durch geringen Material- und Werkzeugeinsatz, geringes Gewicht, geringen Energieverbrauch, geringe Wärmeentwicklung und geringe Abmessungen auszeichnen.

Fig. 4 eine detailliertere schematische Darstellung eines computergestützten Schaltschrankkonfigurationssystems zur Konfiguration eines Schaltschranks.

Ergänzend sei daraufhingewiesen, dass "umfassend" und "aufweisend" keine anderen Elemente oder Schritte ausschließt und die unbestimmten Artikel "eine" oder "ein" keine Vielzahl ausschließen. Ferner sei daraufhingewiesen, dass Merkmale oder Schritte, die mit Verweis auf eines der obigen Ausführungsbeispiele beschrieben worden sind, auch in Kombination mit anderen Merkmalen oder Schritten anderer oben beschriebener Ausführungsbeispiele verwendet werden können. Bezugszeichen in den Ansprüchen sind nicht als Einschränkungen anzusehen.

### Bezugszeichenliste

- 1: Schaltschrankkonfigurationssystem
- 2: Rahmenbedingungsdatensatz
- 10: Klassifikationseinrichtung
- 11: Datenbank
- 12: Datenbank
- 13: Datenbank
- 18: Auswerte- und Simulationseinheit
- 20: Mustererkennungseinheit
- 30: Schaltschrankkonfigurationen
- 40: Entscheidungseinrichtung
- 100: Schaltschrankkonzepte
- 200: Schaltschrankfertigungsanlage
- 201: Fertigungslinie
- 301: Verfahrensschritt
- 302: Verfahrensschritt

## Patentansprüche

1. Computergestütztes Schaltschrankkonfigurationssystem (1), eingerichtet zur Konfiguration eines Schaltschranks, der eine modular aufgebaute Schaltschrankausstattung umfasst, die anwendungsspezifisch aus mehreren elektrischen und/oder elektronischen Einbaumodulen und weiteren optionalen Komponenten zusammengesetzt ist, aufweisend:
eine Recheneinheit mit einer Klassifikationseinrichtung (10) und einer Auswerte- und Simulationseinheit (18);
eine Datenbank (11, 12, 13);
wobei die Klassifikationseinrichtung eingerichtet ist, unter Berücksichtigung eines Rahmenbedingungsdatensatzes (2) eine oder mehrere Schaltschrankkonfigurationen (30) für eine zu regelnde Anlage zu identifizieren, indem sie geeignete Konfigurationen aus einem in der Datenbank gespeicherten historischen Vorratsdatensatz auswählt;
wobei die Auswerte- und Simulationseinheit eingerichtet ist, die unter Berücksichtigung des Rahmenbedingungsdatensatzes identifizierten Schaltschrankkonfigurationen innerhalb eines durch unterschiedliche Parameter aufgespannten Parameterraumes anzupassen, so dass ein Bündel von unterschiedlichen Schaltschrankkonzepten (100) mit jeweils unterschiedlichen Layouts erzeugt wird.

2. Computergestütztes Schaltschrankkonfigurationssystem (1) nach Anspruch 1,
wobei die Auswerte- und Simulationseinheit (18) eingerichtet ist, für jedes Schaltschrankkonzept (100) des Bündels Abweichungen von den im Rahmenbedingungsdatensatz (2) definierten Rahmenbedingungen und gegebenenfalls den sich daraus ergebenden Zielsetzungen zu berechnen und graphisch auszugeben.

3. Computergestütztes Schaltschrankkonfigurationssystem (1) nach einem der vorhergehenden Ansprüche,
wobei der Rahmenbedingungsdatensatz (2) eine gewünschte Spezifikation des Schaltschranks umfasst.

4. Computergestütztes Schaltschrankkonfigurationssystem (1) nach einem der Ansprüche 2 oder 3,
wobei die Zielsetzungen eine Herstellungszeit und/oder die Herstellungskosten des Schaltschranks umfassen.

5. Computergestütztes Schaltschrankkonfigurationssystem (1) nach einem der vorhergehenden Ansprüche,
wobei das Schaltschrankkonfigurationssystem () eingerichtet ist, den Rahmenbedingungsdatensatz (2) mittels eines ersten elektronischen Auswahlformulars zu erstellen.

6. Computergestütztes Schaltschrankkonfigurationssystem (1) nach einem der vorhergehenden Ansprüche, weiter aufweisend:
eine Mustererkennungseinheit (20), welche die Klassifikationseinrichtung (10) verwendet, um die eine oder mehreren Schaltschrankkonfigurationen mittels Mustererkennung zu identifizieren.

7. Computergestütztes Schaltschrankkonfigurationssystem (1) nach Anspruch 6,
wobei die Mustererkennungseinheit (20) zur Mustererkennung Fuzzy-Logik, künstliche Intelligenz oder neuronale Netze einsetzt.

8. Computergestütztes Schaltschrankkonfigurationssystem (1) nach einem der vorhergehenden Ansprüche,
wobei die Auswerte- und Simulationseinheit (18) eingerichtet ist, die Parameter des Parameterraumes mittels eines zweiten elektronischen Auswahlformulars zu erstellen.

9. Computergestütztes Schaltschrankkonfigurationssystem (1) nach einem der vorhergehenden Ansprüche,
wobei die Parameter, welche den Parameterraum aufspannen, Fertigungstiefe, Platzbedarf und Kosten umfassen.

10. Computergestütztes Schaltschrankkonfigurationssystem (1) nach einem der vorhergehenden Ansprüche, weiter aufweisend:
eine Entscheidungseinrichtung (40), eingerichtet zur Auswahl eines Schaltschrankkonzepts aus dem Bündel von unterschiedlichen Schaltschrankkonzepten (100).

11. Computergestütztes Schaltschrankkonfigurationssystem (1) nach Anspruch 10, eingerichtet zum Hinterlegen der Schaltschrankkonfiguration des ausgewählten Schaltschrankkonzepts in der Datenbank (11, 12, 13).

12. Computergestütztes Schaltschrankkonfigurationssystem (1) nach einem der vorhergehenden Ansprüche,
wobei die Auswerte- und Simulationseinheit (18) einen dort implementierten oder dieser zugeordneten Abwandlungsalgorithmus zur Erzeugung mindestens eines alternativen Schaltschrankkonzepts (100), wobei der Abwandlungsalgorithmus zur Abwandlung des Schaltschrankkonzepts in das alternative Schaltschrankkonzepts Werte einer Gütefunktion ermittelt und die Abwandlung derart optimiert, dass die Gütefunktion ein Extremum annimmt.

13. Computergestütztes Schaltschrankkonfigurationssystem (1) nach Anspruch 12,
wobei der Abwandlungsalgorithmus eine parametrierbare Gütefunktion enthält, die mindestens einen vorgegebenen Layout-Optimierungsparameter eines Layout-Optimierungsparametersatzes aufweist.

14. Computergestütztes Schaltschrankkonfigurationssystem (1) nach Anspruch 13,
wobei der Layout-Optimierungsparametersatz einen Raumnutzungsgrad des zur Verfügung stehenden Schaltschrankvolumens im Verhältnis zu geometrischen Abmessungen der hierin zu verbauenden elektrischen und/oder elektronischen Einbaumodule umfasst.

15. Computergestütztes Schaltschrankkonfigurationssystem (1) nach Anspruch 13 oder 14,
wobei der Layout-Optimierungsparametersatz einen thermischen Belastungsgrad unter Berücksichtigung der von den Einbaumodulen erzeugten Abwärme, der Umgebungswärme des Schaltschrankgehäuses und der Wärmeabfuhrleistung einer optionalen Lüfter-/Klimaeinheit umfasst.

16. Computergestütztes Schaltschrankkonfigurationssystem (1) nach einem der Ansprüche 13 bis 15,
wobei der Layout-Optimierungsparametersatz einen elektrischen Energieverbrauchsgrad unter Berücksichtigung zumindest der elektrischen Leistungsaufnahme der Einbaumodule umfasst.

17. Computergestütztes Schaltschrankkonfigurationssystem (1) nach einem der Ansprüche 13 bis 16,
wobei der Layout-Optimierungsparametersatz einen EMV-Grad umfasst, welcher die elektromagnetische Emission der Einbaumodule berücksichtigt.

18. Computergestütztes Schaltschrankkonfigurationssystem (1) nach einem der Ansprüche 13 bis 17,
wobei der Layout-Optimierungsparametersatz einen Verdrahtungslängen-Grad umfasst, um Vorgaben hinsichtlich minimaler oder maximaler Kabellängen bei der Anordnung der Einbaumodule im Schaltschrankgehäuse zu berücksichtigen.

19. Schaltschrankfertigungsanlage (200), eingerichtet zur Fertigung eines Schaltschranks, aufweisend:
ein computergestütztes Schaltschrankkonfigurationssystem (1) nach einem der vorhergehenden Ansprüche;
eine zumindest teilautomatisierte Fertigungslinie (201), eingerichtet zur zumindest teilautomatisierten Montage des Schaltschranks gemäß einem vom Schaltschrankkonfigurationssystem erzeugten Schaltschrankkonzept.

20. Verwendung eines computergestützten Schaltschrankkonfigurationssystems (1) nach einem der Ansprüche 1 bis 18 zur Vollautomatisierten Fertigung eines Schaltschranks.

21. Verfahren zur Konfiguration eines Schaltschranks, der eine modular aufgebaute Schaltschrankausstattung umfasst, die anwendungsspezifisch aus mehreren elektrischen und/oder elektronischen Einbaumodulen und weiteren optionalen Komponenten zusammengesetzt ist, aufweisend die Schritte:
Identifizieren, unter Berücksichtigung eines Rahmenbedingungsdatensatzes (2), eine oder mehrere Schaltschrankkonfigurationen (30) für eine zu regelnde Anlage, indem geeignete Konfigurationen aus einem in einer Datenbank gespeicherten historischen Vorratsdatensatz ausgewählt werden;
Anpassen der unter Berücksichtigung des Rahmenbedingungsdatensatzes identifizierten Schaltschrankkonfigurationen innerhalb eines durch unterschiedliche Parameter aufgespannten Parameterraumes, so dass ein Bündel von unterschiedlichen Schaltschrankkonzepten (100) mit jeweils unterschiedlichen Layouts erzeugt wird;
Auswahl eines Schaltschrankkonzepts mit einem Layout aus dem Bündel von unterschiedlichen Schaltschrankkonzepten.

22. Computerprogrammprodukt mit Programmcodemitteln zur Durchführung des Verfahrens nach Anspruch 21, wenn das Computerprogrammprodukt auf einer Recheneinheit einer Schaltschrankfertigungsanlage (200) nach Anspruch 19 abläuft oder auf einem computerlesbaren Datenträger oder in einem Cloud-Speicher abgespeichert ist.
